# EUROPEAN PATENT APPLICATION

(11) **EP 4 147 775 A1**
(43) Date of publication of application: **15.03.2023**
(21) Application number: 21800313.5
(22) Date of filing: 07.05.2021
(51) Int. Cl.: B01J 21/06, B01J 32/00, B01J 35/10

(54) **METHOD FOR PREPARING A CATALYST FOR ENVIRONMENTAL DECONTAMINATION BY MEANS OF NON-SELECTIVE REDUCTIVE HETEROGENEOUS ELECTROCATALYSIS**

(30) Priority: 08.05.2020 ES 202030409
(71) Applicant: Omelchenko, Elena, 08293 Collbato (ES)
(72) Inventor: TORRECILLA RODRIGUEZ, Luis Manuel, 08293 Collbato (ES); OMELCHENKO, Elena, 08293 Collbato (ES)
(74) Representative: Torras Toll, Jorge
(86) International application number: PCT/ES2021/070321
(87) International publication number: WO 2021/224536

(57) **Abstract**

The invention relates to a method consisting in depositing coating of a semiconductor such as TiO₂ on the surface of a substrate of activated carbon in the form of grain or powder that acts by means of an advanced oxidation-reduction mechanism in environmental decontamination processes, by way of a heterogeneous electrocatalysis system applying an electrical potential having a magnitude equal to or greater than that of the bandgap energy of the semiconductor, which is 3.2 eV in the case of anatase TiO₂, such that an electron rises from the valence band to the conduction band, leaving in its place holes, h+, with enough oxidative capacity to be able to oxidise H₂O and form OH radicals.

## Description

### TECHNICAL FIELD

The object of the present invention is a procedure for preparing a catalyst for Atmospheric Decontamination, Disinfection of the Environment and Sanitation of the Ecosystem that replaces advanced oxidation processes by photocatalysis by creating a more universal and compact system that has been given in denominating Heterogeneous Electrocatalysis.

### BACKGROUND OF THE INVENTION

Nowadays, great attention is paid to the treatment for the elimination of the gases of most concern due to their toxicity in cities, NOx, these compounds formed mainly by NO and NO₂. It is worthwhile, however, to express deep regret for the lack of effective techniques for manipulating the gas that most overwhelms the planet and that already appears as the main cause of cataclysmic events, CO₂.

As we have implied, combustion is the main anthropogenic source of NOx. During combustion, at high temperatures, nitrogen and oxygen, present in the air and, consequently, in the combustion chamber of an engine, or in the chamber of a gas furnace, or in a blast furnace, or in A turbine, to name a few examples, after being absorbed during the intake touch, can react with each other. In the process, NO and then NO₂ is formed. Thus, the relative amounts of NO and NO₂ depend on the high temperatures that may occur during combustion, mainly. There is also a direct dependence on the relative amounts of N₂ and O₂ absorbed during engine fuelling.

So, the application of catalytic methods that remove these gases is of great importance for the control of NOx emissions.

There are currently two methods used in this field: the direct catalytic decomposition of NOx based on ceramics and zeolites exchanged with transition metals and the selective reduction method.

The first of these methods is carried out without the presence of additional reagent and requires expensive metals that are very scarce in nature, such as Pt, Pd, Ru, Rh, so the technology is especially expensive. It also requires high temperatures for its effective operation during catalysis, which forces the catalytic container to be brought closer very close to the exhaust gas outlet, immediately after the exhaust manifold, which is where the gases emerge hottest. This causes the direct attack of soot and other residual compounds, which dirty the surface and settle in the catalytic conduits, impoverishing and reducing the efficiency of the process. In this process, the catalyst undergoes a real poisoning, which can even reach its inhibition. In parallel to this, the technology has a low level of effectiveness, since the surface area in the catalytic ducts is not large enough for all the molecules of the exhaust gases to come into contact with it as they pass and, in turn, with the catalyst housed in it, which implies a high level of permeability and the consequent decrease in performance in the transformation of NOx, as the gases do not touch this surface.

Other technologies that are used have described the use of catalysts based on zeolites exchanged with transition metals, as a possibility for the control of nitrogen oxides emissions [M.lwamoto, H. Yahiro, S. Shundo, Y. Yu- u, N. Mizuno, Shokubai (Catalyst), 32 (1990), 430.]. However, the activity of these catalysts in the decomposition reaction is seriously affected by the presence of O₂, SO₂ and water vapor [M. Iwamoto et al., Stud. Surf. Sci. Catal., 28 (1986) 943; M.lwamoto in M. Misono et al. (editors), Future Opportunities in Catalytic and Separation Technology, Stud. Surf. Sci. Catal., Vol. 54, Elsevier, Amsterdam, 1990, p. 121; M. Iwamoto, H. Hamada, Catal.Today, 10 (1991) 57.2, 3.

In fact, the real problems in cities with diesel engines, due to emissions, have called into question the effectiveness of this catalytic processing technology, causing real scandalous fraud, such as that of the fake Volkswagen engines, in the years 2015-2016, which emitted 40 times more than the limits allowed by regulations, established by the US Environmental Protection Agency (EPA). This fraud cost the German company $17.5 billion in compensation to affected vehicle owners and a $4.3 billion fine to be paid to the U.S. Department of Justice.

The other catalytic aftertreatment technology actively being used in diesel engines today is selective reduction. [F. P. Boer, L. L. Hegedus, T.R. Gouber, K.P. Zak, Chem. Tech. May 1990, 312; G. L. Baverle, S.C. Wu, K. Nobe, Ind. Eng. Chem. Prod. Res. Dev., 14 (1975) 268] This technology foresees the use of urea, as chemical pretreatment of the exhaust gases, before being introduced into the catalyst, which we have already referenced. This process facilitates the generalization of catalysis to the entire mass of gases and increases up to 90% the effectiveness of the conversion treatment by reduction to N₂ and O₂, before being expelled to the atmosphere. However, this technology brings with it the safety problems associated with the use of ammonia [S. Matsuda, T. Kamo, A. Kato, F. Nakajima, T. Kumura, H. Kuroda.lnd. Eng. Chem. Prod. Res. Dev., 21 (1982) 48]

Let us analyse the issues caused by the use of this emerging technology, known, among others like it, and to mention a representative one, a cutting-edge one that has established itself in the market under the commercial name of "AdBlue".

The use of this technology is summarized in a new intermediate system in the treatment by catalytic reduction of exhaust gases, which represents a new mechanism that requires an additional expense to the already expensive direct treatment with the catalyst. This treatment is summarized in a premixing of the exhaust gases with urea. It requires the introduction of an entire storage system of a large volume of liquid urea, its pumping through pipes to a spraying system, the mixing of the gases with the sprayed liquid in a pre-chamber, before entering the catalyst and only after all this, the gases are really neutralized, already on its way through this one. As we can imagine, this treatment, which achieves, according to unscientific information, 90% effectiveness, has a whole series of drawbacks; namely, to name a few of them:
- We must add, to the already bulky, expensive and cumbersome multifunctional mechanism of an engine, a new system in its operation, which increases its cost.
- The use of urea requires special materials, since it is a highly corrosive liquid. This corrosivity is increased by the high temperatures in which it will act, essential for the subsequent treatment of the catalyst. This corrosivity, in turn, affects the catalyst materials themselves, the increase in lime in the ducts (product of the required mixture of urea with 65% demineralized water), with the consequent narrowing of ducts, circulation, and plugging of spray injector orifices.
- Periodic replacement of the urea tank, which can reach 20 litres, (a not insignificant amount), without which the engine cannot work and is blocked by the vehicle's centralized control unit.
- Urgent need to monitor the amount of urea to be introduced before passing through the catalyst, to prevent part of that urea from being released through the exhaust pipe, without first being neutralized in the catalyst. This is particularly important in order not to cause additional pollution to the already damaged atmospheric environment. Additionally, we must add that a 100% suitability in the mixture and the same level of neutralization in the passage through the catalyst, is practically impossible to obtain, as demonstrated by countless examples in day-to-day activities, where it is intended, generally, to reach the suitability. Therefore, a certain amount of urea, mixed with untreated exhaust gases, will inevitably enter the atmosphere and pollute it.
- The mixture with the exhaust gases of the water solution with urea, stored at 20°C., as a mean temperature, rapidly cools the exhaust gases, which goes to the detriment of an effective catalysis which, as noted, needs to be irremediably high temperatures for perfect performance. This problem is found in countries with cold weather;
- It does not treat, by oxidation, which is required for its transformation to CO₂, toxic gases such as CO, so that the danger of expulsion into the atmosphere of this gas, which is as or more dangerous than the treated NOx, remains unresolved. There may even be the added danger that gases, such as CO₂, produced from a normal complete combustion and which is non-toxic, are reduced to CO and then, the problem of CO pollution, which, as mentioned, is extremely toxic, is intensified. In other words, as it is a selective treatment, it prevents the decontamination of all the pollutants that are produced during combustion and adds the possible increase in toxic gases, from neutral gases already obtained from the normal combustion of the engine. Here we must add that treating gases, such as CO₂ and CO is quantitatively much more difficult than NOx, since its percentage of composition in the exhaust gases is much higher, compared with these.

So, in short, both direct catalysis and selective reduction do not evade extremely high costs and the harmful effects that internal combustion engines subject us to, both for engine operating systems and for the ecosystem and environment, which we must clean up.

Patent ES2169935 T3 (07/16/2002), also referred to as European Patent E99101847 (4), also published as EP0935056 A2 (08/11/1999), EP0965056 A3 (01/12/2000), EP0935056 B1 (12.12.2001); Priority number DE19981004429 (02.05.1998); Applicant: ADAM OPEL AG (DE) 65423 Russelsheim; inventors Von Brand, Heinz-Ewo (DE) refers to a system for rapid preheating of exhaust gas catalyst of an internal combustion engine.

In this patent, the need for rapid heating of the catalytic converter at the exhaust outlet of an internal combustion engine is pointed out, so that the work of neutralising the harmful components of the exhaust gases does not invade the external environment during engine start-up. This working condition of the catalytic converters of engines at high temperatures to be effective during the neutralization of the harmful components of the exhaust gases is maintained for the generality of the engines, during the entire operating time. This need is more pronounced during the start-up of a cold engine, which has been idle for some time and, as a result of the usual heat exchange with the external environment, has cooled down.

This patent shows one of the deficiencies indicated in the characteristics of the catalysts that are marketed today, since they cannot guarantee optimal efficiency in catalysis during the entire time that the engine is sending polluting gases into the atmosphere under low temperature conditions and after relatively long periods of shutdown.

The firm URJUSA (Almeria), through two patents, uses natural minerals to provide hydrocarbons, by physical contact, with a significant amount of O₂ to facilitate complete combustion and that they burn, during combustion, to levels of the 95% of its volume (and not just 75-85%, which is usual). In this case, the more complete combustion guarantees a decrease in the levels of CO expulsion into the atmosphere, which is a goal to be achieved.

This patent, although it does not stop having a noble objective, increases the cost of fuel and cannot solve the substantial and main problem of eliminating NOx in exhaust gases.

In the same sense, Peruvian engineers, through a device called EcoEvol^{®}, have created a catalyst that immerses in the fuel tank and optimizes complete combustion in engines, lowering the levels of CO expulsion into the atmosphere. The yield increases by 30%, as they have announced.

The company "03 PROTÉGELO S.L." (Jaén) has presented a catalyst to improve the energy efficiency of engines, which is introduced into the hydrocarbon feed tube.

These patents also do not eliminate the overwhelming problem of toxic NOx gases emitted by engines into the atmosphere.

In a publication of R + D CSIC on July 11, 2017 the following review is published:
"Scientists from the Eduardo Torroja Institute of the CSIC have developed a photocatalyst to eliminate pollutants in the car's exhaust pipe. Photocatalysis, by means of a catalyst triggered by light, allows the elimination of compounds by oxidation or reduction. In this case, the device developed by the CSIC eliminates nitrogen oxide, volatile organic compounds and other carboncontaining particles that are generated by combustion by oxidation".

"The device consists of a material (the photocatalyst) that is placed inside the exhaust pipe, arranged in such a way that it occupies the maximum surface area for the passage of gases, and a lamp (which triggers the chemical reaction), whose wavelength is adjusted to achieve maximum performance".

"In tests carried out in the laboratory, it has been possible to reduce the concentration of nitrogen oxide up to one hundred times (going from between 4000 and 6000 parts per billion to 40 and 60), reaching levels lower than those required by environmental regulations. Researchers are still refining the system to ensure the stability of the photocatalyst."

"The glass that covers the lamp has self-cleaning properties to prevent dirt from the smoke from diminishing efficiency. Furthermore, the device incorporates the possibility of cleaning and eliminating the products deposited on the active centers of the photocatalyst, which could damage it. The photocatalysis process starts when the vehicle's engine is started and stops when the ignition is switched off. Compared to other similar catalytic devices based on chemicals, such as urea, this device has the additional advantage of not generating more CO₂ in itself. Neither does it need replacement of chemical products."

Our experience with such a photocatalyst, based on TiO₂, which is the most stable and durable in this type of function, is very limited by the working surface of the catalyst and it has been shown that the performances are very poor within the limited space of an exhaust pipe. In addition, illumination with light in the Ultraviolet range, with wavelengths less than 400 nm, would not reach all of the catalyst, if, in a hypothetical case, a catalyst with increased surface area could be used by means of a very porous substrate with the catalyst covering all of the large surface area covered by the pores. These materials could be, for example, the aforementioned zeolites, activated carbon, rough fritted ceramics, cellular concrete or spongy metals. In other words, heterogeneous photocatalysis in this type of device is hampered by the limited volume offered by an exhaust pipe.

In summary, the technologies currently used for the dynamic elimination of NOx have substantial limitations and are either inefficient, or they bring with them, in turn, the production of pollutants and corrosive substances that further exacerbate the exhaust gas treatment problem.

### OBJECT OF THE INVENTION

The emergency of the global problem of environmental pollution and climate change, requires a technology that truly solves all these evils at once, that does not exacerbate the situation with partial remedies that can cause and deepen others and that, at the same time, it is an affordable, cheap and durable technology. To get rid of all these problems during the decontamination of engine exhaust gases and, in general, of all NOx and even CO₂ emitting sources, as well as other toxic gases produced during combustion, among which we can point out CO, S₂O, uncombusted hydrocarbon gases and others, the technology we present in the present patent of invention is proposed.

This patent deals with a novel procedure for atmospheric decontamination, disinfection of the environment and sanitation of the ecosystem that replaces the classic advanced oxidation processes through heterogeneous photocatalysis with a new technology that we can call heterogeneous electrocatalysis, which has innumerable advantages over the previous one. This technology finds countless applications in atmospheric sanitation, by eliminating harmful gases produced during the combustion of fossil fuels, such as NO, NO₂, (known as NOx), CO, unburned hydrocarbons, volatile organic compounds (VOCS). These gases can be dynamically removed, directly during the engine exhaust process, which means a true technological advance, since these harmful gases will not have contact, before being decontaminated and purified, with the external environment or, even, they can already be treated statically by collecting in tunnels through which the automotive environment circulates, car parks where they are parked, etc. In the case of industrial decontamination, it provides for the possibility of treatment in chimneys or special reservoirs, intended for the decontamination process, before discharge into the atmosphere. In homes and buildings where these gases are produced, they can be treated in the same way as in the case of industrial treatment.

The technology can eliminate CO₂ and returning pure O₂ to the atmosphere, which means a resounding victory in the fight in which the planet is engaged against climate change and the greenhouse effect. This is of extreme and vital importance in these moments when there is no more important task for human beings than to save the planet from a climate catastrophe of biblical proportions and from the threat of extinction of all ecosystems. It is also an opportunity to continue using the usual energy resources, oil, natural gas, coal, biofuels, etc. in a harmless way, without damaging the atmosphere and the environment, for the necessary time, until man manages to discover and develop a clean, safe and durable technology for his energy supply that does not pose a threat to the Earth.

Given the non-selective nature that manifests the decontaminating and purifying activity of our technology, eliminating without distinction all types of organic pollutants, whatever the composition, it finds wide utility in the elimination of viruses and bacteria, which has been certified by internationally prestigious approved laboratories and institutions, such as the UNESCO Sustainability Chair, attached to the Polytechnic University of Catalonia and the CRESCA Laboratories of this University. In their conclusions, the intense and marked biosidal activity of our compounds and coatings stands out.

It is also important to note that the technology finds prominent use in liquid treatment, for which it can be used and in fact will be used in one of its slopes, for the treatment of wastewater, purification of slurry, purification of sewage waters, as well as treatment of water and industrial waste.

The physical-chemical processes that take place during the combustion of most fossil fuels that humans use, both to obtain direct energy for movement (automotive transport), as well as to obtain electricity, as an energy vector and other forms of obtaining heat for the development of its various activities, release chemically active residual gases into the atmosphere, which can be totally or partially toxic and harmful to your health. Such is the example of gases such as S₂O, CO, NO, NO₂ (generalized in the term NOx) or micro particles that lodge in the lungs and even in the pulmonary alveoli, such as PM2.5, especially dangerous, since they are processed during the respiratory function of oxygen and CO₂ exchange by the blood, damaging this function. They can also contain part of unburned hydrocarbons or volatile organic compounds (VOCs), equally dangerous to health. Some of these gases may be non-toxic, but they are very detrimental to the balance of the planetary ecosystem, as is the case of CO₂, responsible for global warming and, therefore, the main protagonist of current climate change. That is, the internal combustion engines used in transportation and power generation plants, as well as a multitude of energy sources and heat that man uses in his daily work and that is based on the burning of fossil fuels, be these oil and its derivatives, natural gas, coal, wood, etc. they are true predators in the ecological balance of the functioning of the planet and living beings. They constitute the largest source of CO₂ discharge into the atmosphere, the main agent of global warming, as well as dangerous gases of NO and NO₂, as we have indicated. The latter invade cities with pollution and are responsible for chemical smog and acid rain.

Therefore, these NOx deserve special mention and should be the main objective for scientific activity in atmospheric decontamination, as they cause more than 6.5 million premature deaths worldwide, being especially aggressive for people suffering from respiratory diseases and cardiovascular.

Our patent for invention therefore addresses an effective solution to these overwhelming problems of pollution, air pollution and climate change with a technology never before experienced within the multitude of techniques that have been put to the test to solve a problem that strangles society and makes our Nature succumb.

As indicated, gases can be eliminated dynamically, in the tubular tract of the exhaust of the engines towards the atmosphere or statically in a tank or additional treatment reservoir, to which they are brought by collection and pumping.

The main sector that produces a greater amount of NOx is transport, which has a constant growth trend. After this, the main source of emissions are thermal power plants, gases expelled by turbines, refineries, the chemical industry related to the production of ammonia or nitric acid and emissions that come from other sources, such as forest fires, cremation in general, burning of garbage, wood, etc.

The main effects on human health of these compounds are a corrosive action on the skin and respiratory tract, causing redness and severe skin burns. Inhalation in high concentrations and for short periods of time can cause pulmonary edema, the effects of which are not observed until a few hours have passed, aggravated by physical effort. Prolonged exposure can affect the immune system and the lung, resulting in less resistance to infection and irreversible damage to lung tissue.

With regard to the impacts on the environment, it is a substance that has a great importance in the formation of photochemical smog, since, when combined with other atmospheric pollutants, it influences the reactions of ozone formation on the Earth's surface.

Finally, NO₂ is formed from the oxidation of nitric oxide (NO) and has a relatively short life in the atmosphere since it is rapidly oxidized to nitrates (NO₃₋) or to nitric acid (HNO₃), under suitable conditions, causing the Acid rain phenomenon, causing great damage to forests and acidification of surface waters.

### DESCRIPTION OF THE INVENTION

The new technology consists of a decontaminating, disinfecting and biocidal nanometric TiO₂ coating, which is deposited on the surface of an active carbon substrate, with the high surface density and porosity that characterizes it, in the form of grains or powder. The substrate that can be metallic, rough or with a smooth finish, preferably rough, of any roughness that falls within the roughnesses established between Ra 0.02 and 50 microns, but preferably roughnesses between Ra 1.6 to 50 microns, in the form of particles or powder or even in the form of larger bodies, although preferably in the two previous forms; a coating of a photoactive semiconductor of TiO₂ is provided or deposited.

Preferably, the substrate used will be granulated active carbon (hereinafter AC), with the large surface that characterizes it, which can be between 300 m², even less, up to 3000m² per gr., even more.

TiO₂ is a broadband photosensitive semiconductor. To raise an electron from the valence band to the conduction band, this semiconductor needs to resort to the photoelectric effect through the incidence of an energetic photon, with wavelengths from 400nm and less. This type of radiation is thus in the ultraviolet range of the light spectrum. As the photon strikes, an electron is promoted to the conduction shell, as we have noted, and once here it can move freely through the band. In the place that this electron occupied, in the valence band, there is then a hole with a positive charge (h+) with a strong oxidative character, capable of stealing an electron from any element that affects it and oxidizing it. This is the classic mechanism of heterogeneous photocatalysis that is widely used in advanced oxidation reactions, which are very widespread today, as they are very effective, cheap and stable over time. Its greatest utility is given in liquid and gaseous decontamination processes, as well as in disinfectant, bactericidal and viricidal processes. Solar radiation is widely used for activation.

However, together with the fundamental requirement of having a large surface area, a very strict requirement reserved for the photocatalyst, which in some cases is impossible to fulfill, is the direct exposure of that large surface to light. Without this exposure, the phenomenon does not take place.

In our novel device we have solved, very effectively, at least three of the most acute problems that are required of the catalyst and which we will now describe. These are the following:
1^{st}. With AC and, preferably, but not only, the form of TIO₂ in its anatase state (which is the spongy form with the highest surface magnitude of this excellent catalyst), which is ensured by a technology of special disposition and a specific subsequent heat treatment, we have secured a huge active surface for the catalysis and advanced oxidation-reduction processes that we intend to develop;
2^{nd}. Through a process of physical deposition in the state of vapor by low pressure electric arc, we have ensured the requirement of a strong anchoring of the semiconductor on an atomically free surface of the AC, being of crucial importance this last signaling of surface cleanliness to ensure, at the limit of phases, the correct mechanism of transfer and exchange of charges. The junction of the semiconductor TiO₂ with the Active Carbon forms a rectifying potential barrier that favors the transport of electrons from the semiconductor to the element with metallic character, a phenomenon that is automatically established just by putting these elements in contact. Then, the flow of electrons from TiO₂ into the conductor occurs intrinsically, during the equalization of the Fermi energy levels at the interface, resulting from the difference in the values of the output work between the two elements. This fact allows a predisposition to the reduction mechanism if the semiconductor coating is partially established on the surface of the granulated substrate, a question that we have achieved in the system that we have invented. The fact that our technology has a reductive character is very advantageous if we want to reconvert and return the components of the pollutants that would be expelled to the external environment to their initial states, before their formation, preventing the formation of new compounds, which, in turn, could affect the environment. At the same time, the contrary flow mechanism is inhibited, which reinforces the metal in its reducing function and prevents the recombination of the h+ holes and electrons at the interface, when the electric potential is established.
3^{rd}. We have replaced light radiation and the photoelectric effect, as the most widespread classical method in photocatalysis, by the application of an electric potential, which is what it promotes the passage of the electron from the valence band to the conduction band. The magnitude of potential used, as a minimum, has been the one corresponding in energy to that of the photon of light of the ultraviolet range indicated. With this innovative solution, we have extended the activation of the entire immense surface referred to in the first requirement to a space of reduced volume, thanks to the fact that we have literally converted an entire volume into a surface. Now, with this solution, it is not necessary to irradiate the photocatalyst, nor to make light reach its entire surface, an issue that, in some cases, is practically impossible. However, the electrons and the electric potential can reach every corner and surface of the catalyst, no matter how convoluted, microrugal or profuse. The noxious gases or liquids that can be treated with this invention will practically come into contact with the catalyst in all its magnitude, 100%, and there will be no molecules that can escape without having been treated and transformed into harmless and compatible elements with the environment.

This TiO₂ layer, together with the substrate, which in this case has a metallic character, will act by means of a mechanism of oxide of advanced reduction in environmental decontamination processes through a novel heterogeneous electrocatalysis system, which avoids the demands of light radiation from high energy (Ultraviolet A, B or C light or others even more energetic) that are imposed on TiO₂ and other broadband semiconductors, so that they can act efficiently during various decontamination processes, through the known oxidation mechanisms by heterogeneous photocatalysis. But, above all, this technology avoids the need for the entire surface of the semiconductor to be obligatorily exposed to light, an issue that on countless occasions substantially limits and even makes it impossible, in many cases, the use of the effective treatment photocatalytic in operating volumes tight and convoluted structures.

In this invention, the application of an electric potential of equal magnitude, or greater, to that of the forbidden band gap energy, or BandGap, of the semiconductor, which, in the case of TiO₂ anatase is 3.2 eV, is sufficient to raise an electron from the valence band to the conduction band, leaving in its place h+ holes with sufficient oxidative capacity to oxidize H₂O and form OH radicals, extremely oxidizing, which will destroy the pollutants, or act, directly the h+, against them, in different types of oxidation-reduction reactions.

In other words, the novelty of the new technology is based on replacing the photoelectric mechanism, universally used in photocatalysis, which is based on the delivery of energy from quanta of light to a material, in this case a semiconductor, so that it performs the catalytic function; for an electric one, more efficient, versatile and universal in its use. The photocatalytic mechanism, therefore, has serious limitations and demands that are difficult to meet. However, the electricity proposed, through the replacement of radiation by the application of an electric potential to the semiconductor, is of increased quantitative efficiency, easy to implement, simpler, cheaper, effective and does not require the mandatory exposure of the photo catalyst to light.

The union of the TiO₂ semiconductor with the Active Carbon forms a rectifying potential barrier that favors the transport of electrons from the semiconductor to the element with a metallic character, a phenomenon that is automatically established by simply putting these elements in contact. Then, the flow of electrons from TiO₂ to the conductor occurs intrinsically, during the equalization of the Fermi levels at the interface, product of the difference in the values of the output work between the two elements. This fact allows a predisposition to the reducing mechanism in the system that we have invented, which is very advantageous if you want to reconvert and return the pollutants that would be expelled to the external environment to their initial states, before their formation, preventing the formation of new compounds, which, in turn, could affect the environment. At the same time, the contrary flow mechanism is inhibited, which reinforces the metal in its reducing function and prevents the recombination of the h+ holes and electrons at the interphase, when the electric potential is established.

An important aspect to add is that the barrier mechanism can even reduce the intrinsic bandgap gap of the semiconductor below 3.2 eV, which reinforces the described mechanism and reduces the energy necessary for the phenomenon to be established, without detriment of its functionality. Whenever we treat different semiconductors to be used, other than the reference par excellence, the TiO₂, the potential to be established will be adjusted to the specific value of the BandGap for the specific semiconductor (s), or above it, which is not difficult to achieve modifying the voltage value of the source.

There is another very important aspect in the invention and it is the following: a catalytic converter requires a large surface area for efficient performance. It can be said that the more surface a catalyst can have, the more active centers there will be and the greater number of molecules can be catalyzed at the same time. Well, when coating on activated carbon, the TiO₂ will have a large surface to act and this surface will be located in a relatively small volume, like the substrate in question, which can reach 3000m₂/gr. which is equivalent to a colossal specific surface area. In other words, it could be said, literally, that we have extended a whole possible surface to a volume, with the method used. There is even more: by sintering TiO₂ in its anatase form, which is what we choose for our technology, the surface of TiO₂ also grows, in turn, to a spongy state that can increase up to 1000 times its initial value. Hence, the increase in surface area has a multiplying effect on our technology, which is evidenced in the effective results it demonstrates during its performance.

Thus, we must emphasize a change in technology that goes from heterogeneous photocatalysis to heterogeneous electrocatalysis.

The electrocatalytic TiO₂ semiconductor can be deposited by some type of chemical or physical deposition known in the art, such as galvanic, CVD (Chemical Vapor Deposition), Sol Gel, Spin Coating, Molecular Beam Epitaxy, Atomic Beam Epitaxy or PVD (Physical Vapor Deposition). The latter, in turn, by any of the methods used, such as Thermal, Sputtering, Magnetron-Sputtering or Multi Arc; preferably by this last indicated method: the Multi Arch.

Alternatively, TiO₂ is used in its amorphous or rutile form, instead of TiO2 anatase or a combination of both, obtained through specific sintering processes and heat treatments.

On the substrate, a coating of a layer of some other photocatalytic semiconductor can be added, preferably among those indicated below: CdS, SrTiOs, XnO, Nb₂O₅, MoS, FeO₃, WO₃ o SnOs. We have chosen, preferentially, although not limited to a TiO₂ coating. The anchorage to the substrate of this photocatalytic layer must be strong, as we have indicated, and must ensure a certain transmission of charges, without the possibility of polarization or parasitic resistances that hinder or modify the conditions of potential barrier rectifier or Shottkii, required and accompanied by values strictly determined, which will ensure the correct operation of the decontaminating device. For this purpose, an atomic cleaning is strictly necessary, which ensures the total freedom of the valences exposed in the surface layer of the substrate and their availability to receive the host layer, that of the semiconductor. This requirement can only be guaranteed by massive ionic bombardment, which is exclusive to our technology, with parallel heating through an overpotential applied to the substrate that ensures sputtering acceleration in the Debáev layer or by means of a neutral atom accelerator, which we also use in the process. A variant of atomic cleaning can also be by means of Argon heavy ion plasma, produced from an ion source, also present in our know-how.

The AC substrate used can have a surface ranging from 300 to 3000 m² / gr. Preferably a AC of 800 to 3000m²/g will be used, depending on its porosity. Porosity can be microporous (less than 2 nm), mesoporous (2 to 50 nm), and macroporous (more than 50 nm). Preferably mesoporous and macroporous, without ruling out microporous, would be used in specific designations, such as for biocidal clinical treatments. On these particles, in granulometric or powder form, with particle dimensions from 1 to 10 mm for the particulate carbon and less than 1 mm for the powder, the partial deposition of a catalytic TiO₂ coating is carried out, which will be the one that will act, together with the substrate, in advanced oxidation-reduction reactions.

AC is conductive and is the substratum used par excellence in our new technology. However, we also plan to use, as a substitute for this and when circumstances recommend it, other bases for the coating, such as porous and spongy materials, such as grains or powder of a material with a high surface and porous, as it may well be. be aerated concrete, porous silica, zeolites or other similar.

In the case that the base material is not conductive, it is envisaged to carry out a deposition of a metal, prior to the coating of the catalytic semiconductor. In such an embodiment the metallic layer would span the entire surface of the substrate.

In this case, the deposition of a conductive layer of a metal will be carried out before coating, in turn, on this, the electrocatalytic semiconductor.

The deposition of the catalytic semiconductor can also be carried out on some metal, specifically, a decontaminating coating, where the carbon is present in the form of nanotubes that have been made to grow on a metallic substrate that, to increase the catalyzing surface, has been elaborated to the form of grains or powder. On top of this element, already carbonated, the TiO₂ will be deposited similarly.

The decontaminating coating can be technologically worked so that the TiO₂ semiconductor presents increased O₂ vacancies to improve its character as an n-type semiconductor, highly advisable in this technology. This improves the transfer of electrons from the 2p orbital of O₂ to the 3d orbitals of TiO₂, with removal of O₂.

With a similar objective of accentuating the electron donor character of TiO₂ and increasing the efficiency of the n-type semiconductor mechanism, our technology provides for its doping with any transition metal, among which we can point out, by way of example and without limitation, Cu, Mo, V, Ni, W, Fe, Al or with noble metals, such as Ag, Au, Pt, Ru, Rh, Pd. We even envisage a decontamination coating, where the semiconductor has been doped with N₂ or some other non-metal, such as B or S, to improve its electrocatalytic response.

In this same direction, a decontaminating coating is envisaged where the semiconductor has been doped with rare earths Ce, La, Pr, Nd, Sm, Gd, Dy or Eu for the enhancement of its electrocatalytic response.

## Claims

1. Procedure for the preparation of a catalyst for environmental decontamination by non-selective reductive heterogeneous electrocatalysis involving a semiconductor of a transition metals oxide, preferably TiO₂, and substrate of metal **characterized in that** it consists of the partial deposition of a nanometric coating of TiO₂ on one face of the surface of a substrate such as Active Carbon in the form of grains or powder, with a roughness established between Ra 0.02 and 50 microns and a surface ranging from 300 to 3000M²/gr. through a process of physical deposition in the vapor state by low pressure electric arc. This TiO₂ layer together with the substrate, applying an electric potential of equal or greater magnitude to the breach energy of the forbidden band or BandGap of the semiconductor, forms a rectifying potential barrier that favors the transport of electrons from the TiO₂ to the Active Carbon and originates a reducing mechanism at the same time that inhibits the opposite flow of charges, reinforcing the metal in its reducing function and preventing the recombination of h+ holes and e- electrons at the interface, when the electric potential is established.

2. Procedure according to first claim **characterized in that** the coating used is TiO₂ anatase.

3. Procedure according to first claim **characterized in that** the coating used is TiO₂ in its amorphous or rutile form or a combination of both.

4. Procedure according to first claim **characterized in that** the substrate used is a material with a high surface and porous, such as cellular concrete, porous silica, zeolites or another analogous, for which the deposition of a conductive layer of an intermediate metal between the TiO₂ layer and substrate.

5. Procedure according to the first claim **characterized in that** the carbon is present in the form of nanotubes on a metallic substrate that has been processed to the form of grains or powder on which TiO₂ is similarly deposited.

6. Procedure according to first claim **characterized in that** the TiO₂ coating is mixed with a photocatalytic semiconductor oxide, preferably CdS, SrTiOs, ZnO, Nb₂O₅, MoS, Fe₂O₃, WO₃ o SnO₃ or a mixture of them.

7. Procedure according to first claim and from third to six, **characterized in that** the TiO₂ has been worked with increased O₂ vacancies.

8. Procedure according to the first and sixth claims, **characterized in that** the TiO₂ has been doped with any transition metal such as Cu, Mo, V, Ni, W, Fe, Al or with noble metals, such as Ag, Au, Pt, Ru, Rh, Pd.

9. Procedure according to first claim **characterized in that** TiO₂ has been doped with N₂ or some other non-metal, such as B or S.

10. Procedure according to first and sixth claim **characterized in that** TiO₂ has been doped with rare earths Ce, La, Pr, Nd, Sm, Gd, Dy or Eu.
